# EUROPEAN PATENT SPECIFICATION

(11) **EP 3 047 498 B1**
(45) Date of publication and mention of the grant of the patent: **11.09.2019**
(21) Application number: 14771283.0
(22) Date of filing: 18.09.2014
(51) Int. Cl.: H01H 50/14, H05K 3/30, H01R 12/58

(54) **ACTIVE ELECTRICAL COMPONENT**
AKTIVES ELEKTRISCHES BAUELEMENT
COMPOSANT ÉLECTRIQUE ACTIF

(30) Priority: 20.09.2013 DE 102013219009
(43) Date of publication of application: 27.07.2016
(73) Proprietor: TE Connectivity Germany GmbH, 64625 Bensheim (DE)
(72) Inventor: BIEHL, Wilfried, 13593 Berlin (DE); ZIEGLER, Titus, 10179 Berlin (DE); KOCH, Harry, 12105 Berlin (DE); HAEHNEL, Thomas, 14199 Berlin (DE)
(74) Representative: Grünecker Patent- und Rechtsanwälte PartG mbB
(86) International application number: PCT/EP2014/069864
(87) International publication number: WO 2015/040099

(56) References cited:
- DE-A1- 19 618 497
- DE-C1- 3 925 958
- US-A- 5 801 930

## Description

The invention relates to an active electrical component, in particular a switching element such as a relay or a contactor.

Such components are often connected to a counter-element in an electrically conductive manner by means of a contact and a counter-contact. For example, they may have a plug type contact which is inserted into a mating plug type contact. In this instance, only small forces are required to insert and subsequently separate the connection. Such a connection is thus unreliable since it can be readily separated unintentionally. In another solution from the prior art, the contact and the counter-contact are soldered to each other. However, this leads to thermal loading and is complex in terms of production technology.

US 5,801,930 A discloses a printed circuit board relay having a base body in which connecting elements that are cut from a sheet-metal panel are embedded essentially parallel to a base plane of the relay. The connecting elements project sideways from the base body and are bent downwards in order to form push-in posts that are at right angles to the base plate. The push-in posts include a channel-shaped section having a bend along a longitudinal axis and the centre of each push-in post is offset with respect to the outer side of the connecting element. A portion of this channel-shaped section is located outside the contour of the base body, so a pushing-in shoulder is formed at the upper edge of the channel-section.

An object of the invention is to provide an active electrical component which can be readily fitted in a reliable manner to the counter-element and which is suitable in particular for high currents.

According to the invention, this is achieved by an active electrical component, according to independent claim 1. Further embodiments are defined in the dependent claims. The component can be readily connected to a counter-element by the two being connected to each other. In this instance, greater forces than normal can be used since the force transmission structure transmits the forces to the contact from the side of the component opposite the contact without damaging other elements at the inner side. The connection produced in this manner is more reliable as a result of the greater insertion forces since it cannot be so readily separated. Furthermore, high currents can be transmitted therewith.

The force transmission structure is constructed as a carrier frame for the component. It carries other elements of the component. The force transmission structure acts as a support for the component or for members of the component. Therefore, the force transmission structure in this instance carries out a dual function, whereby other load-bearing elements of the component may become superfluous and the structural size of the component is thereby reduced.

The solution according to the invention can be further improved by means of the following developments and embodiments which are each advantageous per se.

A particularly good force transmission with minimal material use is produced due to the force transmission structure that in this invention extends in a linear manner from the contact through the component.

In order to be able to introduce the force into the force transmission structure in an effective manner, the force transmission structure may terminate in a pressing face. In order to configure the force transmission in a particularly efficient manner and to prevent lateral displacement during a pressing action, in an advantageous embodiment, at the side of the component opposite the contact, the force transmission structure terminates in a pressing face which is arranged in alignment with the contact with respect to the insertion direction.

In order also to be able to connect the component to the counter-element when a housing is already fitted to the component, the pressing face may be formed by the housing.

When the pressing face is formed by the housing, the pressing face can at least be reinforced with respect to the immediate environment in order to be able to receive greater forces. For example, a housing may have a greater wall thickness in the region of the pressing face.

In an advantageous embodiment, the contact extends as a member of the force transmission structure as far as the side of the component opposite it. The force transmission structure may be constructed in a monolithic manner. It may be integral with the contact. Such a component is particularly simple to produce and ensures reliable force transmission. At the side opposite the contact, the force transmission structure may be covered by a housing. In another embodiment, the force transmission structure may comprise a plurality of elements which are connected to each other and/or which are in abutment with each other. Individual members may substantially ensure only mechanical stability whilst other members are also electrically conductive and, for example, enable an electrical connection.

In an advantageous embodiment, a plurality of contacts may be arranged at a lower side of the component, the insertion direction extending perpendicularly to the lower side. In such an embodiment, electrical connections can thus be produced on the plurality of contacts at the same time by the component being fitted on the counter-element.

If a plurality of contacts are arranged at a lower side of the component, in a particularly advantageous embodiment the contacts may extend inside the base face of the lower side away from the lower side. The surface-area required to fit the component on the counter-element is thereby not increased.

The contact may be constructed as a socket or a connector. It is advantageously constructed as a connector since no specific counter-contact then has to be present on the counter-element. Instead, a hole or a bore is sufficient for the contacting.

In a particularly advantageous embodiment, the contact is constructed as a pressing contact. Pressing contacts are conventional, for example, in solder-free contacting arrangements of components on printed circuit boards. Such a pressing contact may, for example, be constructed in such a manner that it produces a high resilient force transversely relative to the insertion direction and consequently enables reliable contact with a high current-bearing capacity.

It is possible to use as a counter-element in particular a printed circuit board or a lead frame. The counter-contacts in this instance may be constructed, for example, as bores or holes. High mechanical stability is thereby ensured.

If a plurality of contacts are present, with the contacts each having a pressing face, in an advantageous embodiment the pressing faces may terminate in a plane. The connection is thereby particularly simple since all the contacts can be inserted at the same time onto the counter-contacts with a tool which has a planar face. In an alternative embodiment, the pressing faces may have different positions and/or orientations. For example, an encoding possibility can thereby be achieved for an assembly tool so that the component can be fitted to the counter-element only in one correct orientation.

The component may have a coil and an armature which can be moved by the coil. Advantageously, the movement direction of the armature then extends perpendicularly relative to the insertion direction. The direction of the electrical switching function is thereby decoupled from the insertion direction. The high insertion forces consequently have no influence on the switching movement of the armature having narrow tolerances.

In an advantageous embodiment, the force transmission structure is constructed as a rigid member or a chain of a plurality of rigid members which are connected to each other and which are in abutment with each other at least when a force is applied to the chain in the insertion direction. The rigid members are in this instance rigid at least in the insertion direction, preferably also in other directions. The action of a force in a direction thus does not lead to a change of the length of a chain element in the direction of the action of the force.

The invention is explained in greater detail below with reference to the drawings by way of example. The embodiments described constitute only possible embodiments, but in which the individual features, as described above, can be combined or omitted independently of each other.

In the drawings:
Figure 1 is a schematic, partially sectioned perspective view of a first embodiment of a component according to the invention;
Figure 2 is a schematic, perspective view of a second embodiment of a component according to the invention,
Figure 3 is a schematic side view of the second embodiment of Figure 2;
Figure 4 is a schematic view of the second embodiment from below.

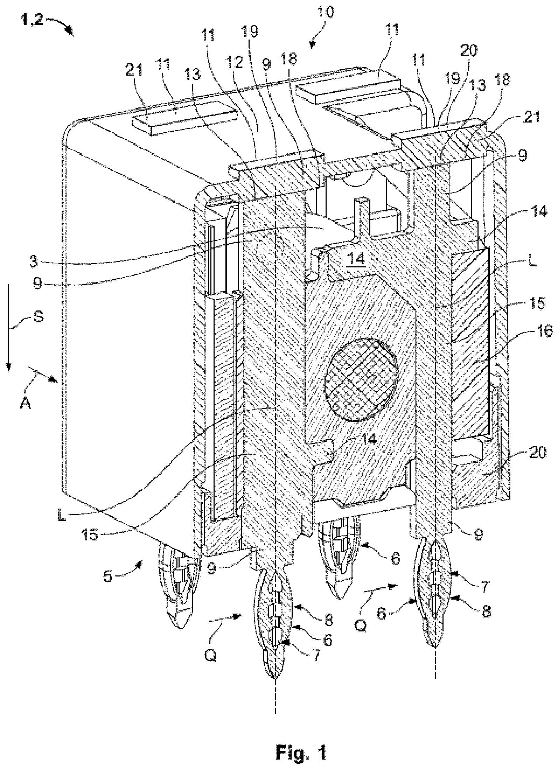

Figure 1 is a partially sectioned view of an active electrical component 1. The active electrical component 1 is a relay 2. A coil 3 of the relay 2 can be switched using currents of different strengths. In this instance, an armature 4 can be moved in and counter to a movement direction A.

The component 1 is constructed to be connected to a counter-element. To this end, it has at a lower side 5 a plurality of contacts 6 which are constructed in this instance as plug type contacts 7 for insertion in a socket (not shown). The contacts 6 can be connected in an insertion direction S to a counter-contact. The counter-contact may, for example, be a socket or a hole. The contacts 6 are constructed as pressing contacts 8. They are in the form of an eye of a needle, metal sheets which act as springs being arranged in the eye of the needle so that, in a transverse direction Q which extends transversely relative to the insertion direction, a high resilient force is produced. A high retention force in the counter-contact and a high current-carrying capacity of the connection are thereby achieved.

The component 1 has a plurality of force transmission structures 9 which extend to the contacts 6 from a side 10 opposite the contacts 6 in a continuous manner. The force transmission structures 9 enable a force to be transmitted to the contacts 6 from the side 10 opposite the contacts 6 without mechanically loading other members of the component 1. In particular, the force transmission structures 9 can be used in order to connect the component 1 to a counter-element by force being applied at the side 10 opposite the contacts 6 in the insertion direction S. The force transmission structures 9 enable the application of high forces which are required to connect the contacts 6 to the counter-contacts in a mechanically stable manner and so as to conduct a high current.

In order to construct the force transmission structures 9 in the most stable manner possible, they extend in a linear manner from the contacts 6 through the component 1. They extend in the load directions L. In this instance, the force transmission structures terminate in pressing faces 11 which are arranged in alignment with the contacts 6 with respect to the insertion direction S. In the embodiment shown in this instance, the pressing faces 11 are formed by a housing 12. In this instance, the pressing faces 11 are reinforced with respect to their immediate environment in order to be able to absorb high forces. The wall thickness of the housing 12 is thicker in the region of the pressing faces 11 than in other regions. A thickened portion 21 of the housing 12 is delimited in and counter to the insertion direction S by internal faces 18 and external faces 19 which each extend perpendicularly relative to the insertion direction S.

The housing 12 is in abutment with the remainder of the force transmission structures 9 in the region of the pressing faces 11. The inner faces 18 of the thickened portion 21 of the housing 12 are in direct abutment with end faces 13 of the remainder of the force transmission structure 9. When a force acts on the pressing faces 11 in the insertion direction S, this is transmitted directly into the remainder of the force transmission structures 9, for example, without the housing 12 bending.

The housing 12 may, for example, comprise metal or plastics material. In order to keep production costs low, the housing 12 may, for example, be produced from a thermoplastic plastics material in an injection-moulding method. The use of other materials is also possible.

The component 1 has a plurality of contacts 6 which are arranged on the lower side 5. The contacts 6 extend in each case perpendicularly from the lower side 5 in the insertion direction S away from the lower side 5. The contacts 6 extend in this instance inside the base face of the lower side 5 away from the lower side 5. They are thus not located laterally beside the component 1, whereby the lateral structural size of the component 1 does not increase.

The force transmission structures 9 are constructed in this instance as chains of rigid members. They each comprise a member which comprises the contact 6 and is integral therewith, and a member of the housing 12. These two members are in mutual abutment and thus ensure a continuous structure, which enables the force to be transmitted to the contact 6 from the side 10 opposite the contact 6 without other members of the component 1, such as the coil 3, being excessively mechanically loaded and potentially damaged. A force transmission structure 9 is constructed in this instance by a chain of two rigid members. In other embodiments, the force transmission structure may also comprise more than two rigid members, for example, three, four or even more rigid members. The individual rigid members may in this instance have different properties. A rigid member may, for instance, be particularly stable and be used for mechanical securing. Another rigid member may be electrically conductive and be used for electrical contacting.

The force transmission structures 9 each have side elements 14, to which other members of the component 1 are fitted. The force transmission structures 9 may act as a carrier frame 15 for the component 1. For example, portions of the coil member 16 are fitted to lateral elements 14. Furthermore, a base portion 20 of the component 1 is fitted to the force transmission structure 9.

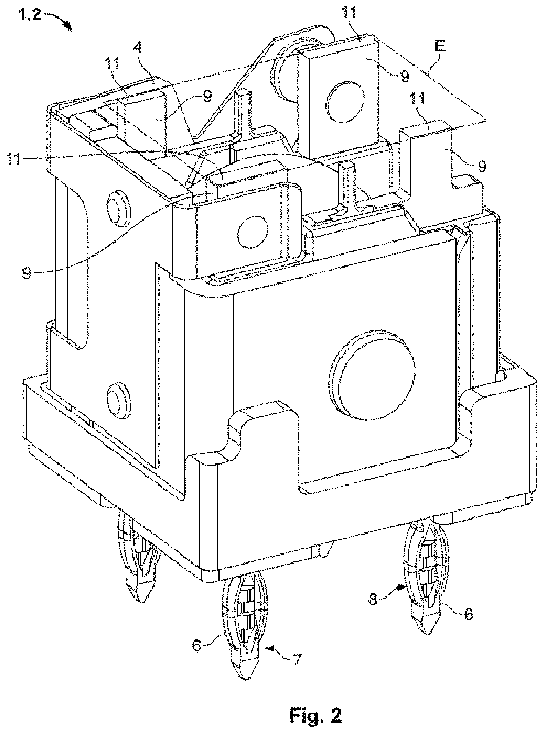

Figure 2 illustrates a second embodiment of a component 1. It is constructed in a similar manner to the embodiment in Figure 1, but has no housing 12. The pressing faces 11 are arranged at the sides of the force transmission structure 9 opposite the contacts 6. The force transmission structures 9 are in this instance formed by a single rigid member, respectively. The rigid members are each integral with the contacts 6.

The pressing faces 11 are located in a common plane E so that a planar pressing tool can be used. In an alternative embodiment, the pressing faces 11 could also be located in different planes and/or have different orientations. For example, the pressing faces 11 could provide an encoding possibility in order to prevent incorrect assembly of the component 1. For example, a pressing face 11 could protrude from a plane formed by the other pressing faces 11. Together with a corresponding assembly tool, this would enable assembly only in a single orientation.

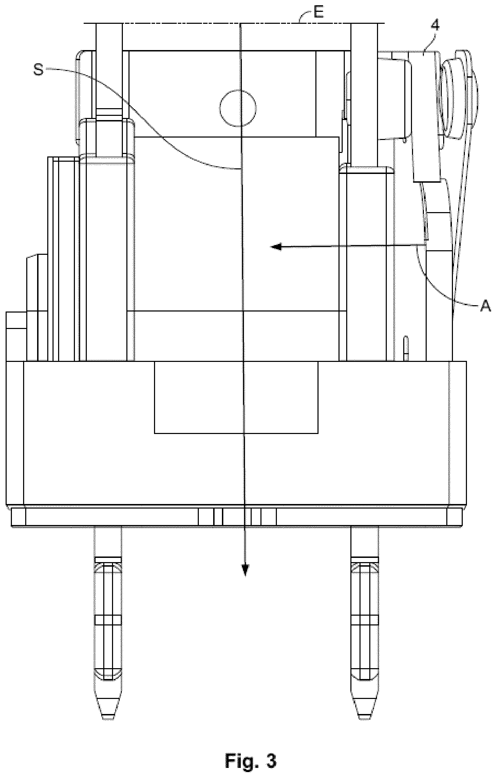

Figure 3 is a side view of the second embodiment of Figure 2. It can be seen in particular that the insertion direction S extends perpendicularly relative to the movement direction A, in which the armature 4 is moved by the coil 3. A switching movement of the armature 4, which is subjected to small tolerances, is thereby not influenced by the high insertion forces in the insertion direction S since the insertion in the insertion direction S is decoupled from the movement of the armature 4 in the movement direction A.

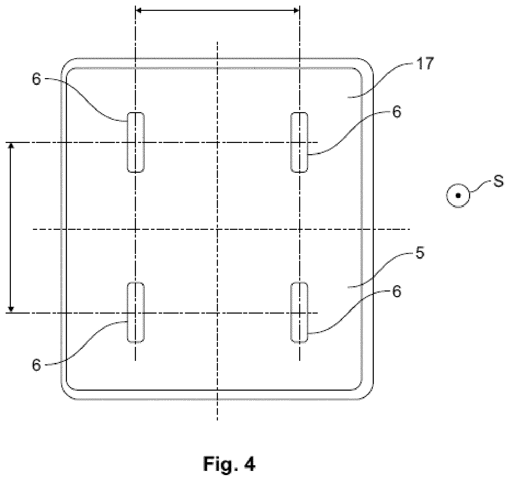

Figure 4 shows the second embodiment from below. It can be seen here in particular that the contacts 6 are located inside the base face 17 of the lower side 5. They therefore do not protrude laterally. All the force transmission structures 9 do not protrude laterally beyond this base face 17. The space required to fit the component 1 thereby substantially corresponds to the base face 17.

The force transmission structures 9 shown in Figures 2 to 4 are each integral with the contacts 6. They are punched from a metal sheet. Of course, a force transmission structure 9 may also, for example, be produced in a different manner, for example, by means of casting or forging. Furthermore, the force transmission structure 9 does not have to be integral with the contacts 6, but may also comprise a plurality of elements which are, for example, joined together in a flush manner in the insertion direction S.

### Reference Numerals

- 1: Component
- 2: Relay
- 3: Coil
- 4: Armature
- 5: Lower side
- 6: Contact
- 7: Connector
- 8: Pressing contact
- 9: Force transmission structure
- 10: Side opposite the contact
- 11: Pressing face
- 12: Housing
- 13: End face
- 14: Lateral element
- 15: Carrier frame
- 16: Portion of the coil member
- 17: Base face
- 18: Inner face
- 19: Outer face
- 20: Base portion
- 21: Thickened portion
- A: Movement direction
- E: Plane
- L: Load direction
- S: Insertion direction

## Claims

1. Active electrical component (1), in particular a switching element such as a relay (2) or a contactor, having at least one contact (6) which is accessible from the outer side (5) for connection in an insertion direction (S) to a counter-contact of a counter-element and having at least one force transmission structure (9) which extends to the contact (6) in a continuous manner from a side (10) of the active electrical component (1) opposite the contact (6), wherein the force transmission structure (9) is constructed as a carrier frame (15) for the active electrical component (1) wherein the force transmission structure (9) has side elements (14), to which other members of the electrical component (1) are fitted, **characterized in that** the force transmission structure (9) extends in a linear manner from the contact (6) through the active electrical component (1).

2. Active electrical component (1) according to either claim 1, wherein, at the side (10) of the component (1) opposite the contact (6), the force transmission structure (9) terminates in a pressing face (11) which is arranged in alignment with the contact (6) with respect to the insertion direction (S).

3. Active electrical component (1) according to claim 2, wherein the pressing face (11) is formed by a housing (12).

4. Active electrical component (1) according to claim 3, wherein the pressing face (11) is reinforced at least with respect to the immediate environment thereof.

5. Active electrical component (1) according to any one of claims 1 to 4, wherein the contact (6) extends as a member of the force transmission structure (9) as far as the side (10) of the component (1) opposite it.

6. Active electrical component (1) according to any one of claims 1 to 5, wherein a plurality of contacts (6) are arranged at a lower side (5) of the component (1) and the insertion direction (S) extends perpendicularly to the lower side (5).

7. Active electrical component (1) according to claim 6, wherein the contacts (6) extend inside the base face (17) of the lower side (5) away from the lower side (5).

8. Active electrical component (1) according to any one of claims 1 to 7, wherein pressing faces (11) of a plurality of contacts are located in a plane (E).

9. Active electrical component (1) according to any one of claims 1 to 8, wherein the component (1) has a coil (3) and an armature (4) which can be moved by the coil (3), wherein the movement direction (A) of the armature (4) extends perpendicularly relative to the insertion direction (S).

10. Active electrical component (1) according to any one of claims 1 to 9, wherein the force transmission structure (9) is constructed as a rigid member or a chain of a plurality of rigid members which are connected to each other and which are in abutment with each other at least when a force is applied to the chain in the insertion direction (S).

11. Active electrical component (1) according to any one of claims 1 to 10, wherein the contact (6) is constructed as a pressing contact (8).

## Patentansprüche

1. Aktive elektrische Komponente (1), insbesondere ein Schaltelement wie ein Relais (2) oder ein Schütz, mit wenigstens einem Kontakt (6), der von der Außenseite (5) zum Verbinden in einer Einsetzrichtung (S) mit einem Gegenkontakt eines Gegenelements zugänglich ist, und mit wenigstens einer Kraftübertragungsstruktur (9), die sich zum Kontakt (6) auf eine durchgehende Weise von einer Seite (10) der aktiven elektrischen Komponente (1) gegenüber dem Kontakt (6) erstreckt, wobei die Kraftübertragungsstruktur (9) als ein Trägerrahmen (15) für die aktive elektrische Komponente (1) konstruiert ist, wobei die Kraftübertragungsstruktur (9) Seitenelemente (14) aufweist, an die andere Elemente der elektrischen Komponente (1) montiert sind, **dadurch gekennzeichnet, dass** sich die Kraftübertragungsstruktur (9) auf eine lineare Weise vom Kontakt (6) durch die aktive elektrische Komponente (1) erstreckt.

2. Aktive elektrische Komponente (1) nach Anspruch 1, wobei an der Seite (10) der Komponente (1) gegenüber dem Kontakt (6) die Kraftübertragungsstruktur (9) in einer Druckfläche (11) endet, die in Ausrichtung mit dem Kontakt (6) in Bezug auf die Einsetzrichtung (S) angeordnet ist.

3. Aktive elektrische Komponente (1) nach Anspruch 2, wobei die Druckfläche (11) von einem Gehäuse (12) gebildet wird.

4. Aktive elektrische Komponente (1) nach Anspruch 3, wobei die Druckfläche (11) wenigstens in Bezug auf die unmittelbare Umgebung von dieser verstärkt ist.

5. Aktive elektrische Komponente (1) nach einem der Ansprüche 1 bis 4, wobei sich der Kontakt (6) als ein Element der Kraftübertragungsstruktur (9) so weit wie die Seite (10) der Komponente (1) gegenüber erstreckt.

6. Aktive elektrische Komponente (1) nach einem der Ansprüche 1 bis 5, wobei eine Vielzahl von Kontakten (6) an einer unteren Seite (5) der Komponente (1) angeordnet ist und sich die Einsetzrichtung (S) senkrecht zur unteren Seite (5) erstreckt.

7. Aktive elektrische Komponente (1) nach Anspruch 6, wobei sich die Kontakte (6) in der Basisfläche (17) der unteren Seite (5) von der unteren Seite (5) weg erstrecken.

8. Aktive elektrische Komponente (1) nach einem der Ansprüche 1 bis 7, wobei Druckflächen (11) einer Vielzahl von Kontakten auf einer Ebene (E) angeordnet sind.

9. Aktive elektrische Komponente (1) nach einem der Ansprüche 1 bis 8, wobei die Komponente (1) eine Spule (3) und einen Anker (4), der von der Spule (3) bewegt werden kann, aufweist, wobei sich die Bewegungsrichtung (A) des Ankers (4) senkrecht relativ zur Einsetzrichtung (S) erstreckt.

10. Aktive elektrische Komponente (1) nach einem der Ansprüche 1 bis 9, wobei die Kraftübertragungsstruktur (9) als ein starres Element oder eine Kette einer Vielzahl von starren Elementen, die miteinander verbunden sind und die aneinander anstoßen, wenigstens wenn eine Kraft auf die Kette in der Einsetzrichtung (S) angewendet wird, aufgebaut ist.

11. Aktive elektrische Komponente (1) nach einem der Ansprüche 1 bis 10, wobei der Kontakt (6) als ein Druckkontakt (8) aufgebaut ist.

## Revendications

1. Composant électrique actif (1), en particulier un élément de commutation tel qu'un relais (2) ou un contacteur, ayant au moins un contact (6) qui est accessible depuis le côté extérieur (5) pour une connexion dans une direction d'insertion (S) à un contre-contact d'un contre-élément et ayant au moins une structure de transmission de force (9) qui s'étend jusqu'au contact (6) d'une manière continue à partir d'un côté (10) du composant électrique actif (1) opposé au contact (6), dans lequel la structure de transmission de force (9) est conçue sous forme un cadre porteur (15) pour le composant électrique actif (1)
dans lequel la structure de transmission de force (9) présente des éléments latéraux (14), sur lesquels sont montés d'autres éléments du composant électrique (1), **caractérisé en ce que** la structure de transmission de force (9) s'étend d'une manière linéaire depuis le contact (6) à travers le composant électrique actif (1).

2. Composant électrique actif (1) selon la revendication 1, dans lequel, au niveau du côté (10) du composant (1) opposé au contact (6), la structure de transmission de force (9) se termine dans une face de pression (11) qui est disposée en alignement avec le contact (6) par rapport à la direction d'insertion (S).

3. Composant électrique actif (1) selon la revendication 2, dans lequel la face de pression (11) est formée par un boîtier (12).

4. Composant électrique actif (1) selon la revendication 3, dans lequel la face de pression (11) est renforcée au moins par rapport à l'environnement immédiat de celle-ci.

5. Composant électrique actif (1) selon l'une quelconque des revendications 1 à 4, dans lequel le contact (6) s'étend sous forme d'un élément de la structure de transmission de force (9) aussi loin que le côté (10) du composant (1) opposé à celui-ci.

6. Composant électrique actif (1) selon l'une quelconque des revendications 1 à 5, dans lequel une pluralité de contacts (6) sont disposés au niveau d'un côté inférieur (5) du composant (1) et la direction d'insertion (S) s'étend perpendiculairement vers le côté inférieur (5).

7. Composant électrique actif (1) selon la revendication 6, dans lequel les contacts (6) s'étendent à l'intérieur de la face de base (17) du côté inférieur (5) à l'opposé du côté inférieur (5).

8. Composant électrique actif (1) selon l'une quelconque des revendications 1 à 7, dans lequel des faces de pression (11) d'une pluralité de contacts sont situées dans un plan (E).

9. Composant électrique actif (1) selon l'une quelconque des revendications 1 à 8, dans lequel le composant (1) comporte une bobine (3) et une armature (4) pouvant être déplacée par la bobine (3), dans lequel le la direction de déplacement (A) de l'armature (4) s'étend perpendiculairement par rapport à la direction d'insertion (S).

10. Composant électrique actif (1) selon l'une quelconque des revendications 1 à 9, dans lequel la structure de transmission de force (9) est construite sous forme d'un élément rigide ou d'une chaîne d'une pluralité d'éléments rigides qui sont connectés les uns aux autres et qui sont adossés les aux autres au moins lorsqu'une force est appliquée à la chaîne dans la direction d'insertion (S).

11. Composant électrique actif (1) selon l'une quelconque des revendications 1 à 10, dans lequel le contact (6) est conçu sous forme d'un contact de pression (8).
